# FASCICULE DE BREVET EUROPEEN

(11) **EP 0 915 643 B1**
(45) Date de publication et mention de la délivrance du brevet: **21.12.2005**
(21) Numéro de dépôt: 98402685.6
(22) Date de dépôt: 28.10.1998
(51) Int. Cl.: H05K 13/00

(54) **Dispositif de maintien pour panneaux de circuit imprimé**
Vorrichtung zum Festlegen von Schaltungsplatinen
Holding device for printed circuit boards

(30) Priorité: 07.11.1997 FR 9714022
(43) Date de publication de la demande: 12.05.1999
(73) Titulaire: AUTOMA-TECH, 27100 Val de Reuil (FR)
(72) Inventeur: Sorel, Alain, 27180 Les Baux Sainte Croix (FR); Germond, Xavier, 27000 Evreux (FR)
(74) Mandataire: Dronne, Guy

(56) Documents cités:
- EP-A- 0 404 577
- DE-A- 4 108 846
- DE-A- 4 339 092
- US-A- 4 700 488
- US-A- 4 951 240

## Description

La présente invention a pour objet un dispositif de maintien pour panneaux de circuit imprimé.

Par dispositif de maintien, il faut entendre un système qui permet de maintenir la stricte planéité d'un panneau de circuit imprimé quelles que soient son épaisseur et ses dimensions.

On sait que lors de la réalisation de circuits imprimés, on part d'un support isolant revêtu de cuivre recto/verso, d'épaisseur et de dimensions variables.

Pour réaliser un certain nombre d'opérations sur ce support isolant en vue de l'élaboration du circuit imprimé, il est le plus souvent nécessaire que, pour réaliser lesdites opérations, le panneau de circuit imprimé soit rigoureusement plan. Cela est nécessaire par exemple lorsque l'on veut réaliser des opérations de poinçonnage de ce panneau afin que la localisation des trous soit rigoureusement respectée. Cela est également nécessaire lorsque l'on veut réaliser une opération par exemple de photogravure d'un dépôt conducteur ou autre réalisé sur le support isolant afin de garantir le strict respect de la géométrie de la photogravure de la couche déposée.

Les documents DE 4339092, US 4700488 et DE 4108846 décrivent des machines de maintien de panneaux de circuits imprimés basés sur la saisie des bords parallèles du panneau.

Cependant, dans ces machines, les moyens de saisie des bords du panneau sont insuffisants pour assurer le maintien de la planéité du panneau sans prise de flèche surtout dans le cas où ces panneaux ont des dimensions importantes et un poids également important.

Un objet de la présente invention est de fournir un dispositif de maintien de panneaux de circuit imprimé qui puisse s'adapter à différentes dimensions de panneaux tout en assurant une très bonne planéité quelles que soient l'épaisseur et les dimensions des côtés dudit panneau.

Pour atteindre ce but, selon l'invention, le dispositif de maintien d'un panneau de circuit imprimé présentant deux bords sensiblement parallèles se caractérise en ce qu'il comprend :
un bâti
des premiers moyens pour saisir un premier bord dudit panneau, chaque moyen de saisie comportant une première pièce formant une surface plane de serrage et une deuxième pièce disposée en regard de la surface plane de serrage, ladite deuxième pièce comportant une pluralité de tiges montées coulissantes selon une direction orthogonale à ladite surface de serrage et se terminant par une extrémité pointue, et des moyens pour déplacer lesdites tiges par rapport à ladite deuxième pièce pour rapprocher lesdites extrémités pointues de ladite surface de serrage plane,
des deuxièmes moyens pour saisir le deuxième bord dudit panneau ; et
des moyens pour appliquer une force d'écartement entre les premiers et deuxièmes moyens de saisie, par quoi ledit panneau est maintenu plan.

Le panneau étant saisi par deux bords parallèles et une traction étant exercée sur ces deux bords, ce panneau est maintenu avec une grande précision de planéité quelles que soient ses dimensions et son épaisseur.

Les moyens de saisie comprennent des tiges qui se terminent en forme de pointes qui sont disposées en regard d'une surface de serrage. Les deux faces du panneau à proximité de son bord sont ainsi maintenues par la pression exercée par les pointes des tiges sur une des faces du panneau, l'autre face étant bloquée par la surface de serrage qui constitue également une surface d'appui pour la face inférieure du bord du panneau.

Dans un mode perfectionné de réalisation, chaque moyen de saisie du panneau comporte deux surfaces de serrage, une de ces surfaces étant équipée des tiges à extrémités pointues.

On comprend qu'on obtient ainsi une force de maintien suffisante grâce à la présence des pointes sans avoir à exercer une pression importante sur les deux surfaces de serrage. On comprend également que dans les modes de réalisation utilisant deux surfaces de serrage de dimension suffisante, on réalise une correction mécanique très efficace de la flèche éventuelle du panneau du circuit imprimé, correction qui s'ajoute à celle résultant de la traction exercée entre les deux moyens de saisie des bords opposés du panneau.

D'autres caractéristiques et avantages de l'invention apparaîtront mieux à la lecture de la description qui suit de plusieurs modes de réalisation de l'invention donnés à titre d'exemples non limitatifs. La description se réfère aux figures annexées sur lesquelles :
- La figure 1 est une vue très schématique montrant l'ensemble du dispositif de maintien ;
- La figure 2 est une vue de côté d'un moyen de saisie du bord du panneau ;
- La figure 3 est une vue de dessus du moyen de saisie représenté sur la figure 2 ;
- La figure 4 est une vue en coupe transversale d'un mode détaillé de réalisation d'un élément de serrage ; et
- La figure 5 est une vue partielle montrant une variante de réalisation dans laquelle les moyens de maintien sont équipés de moyens de déplacement du panneau.

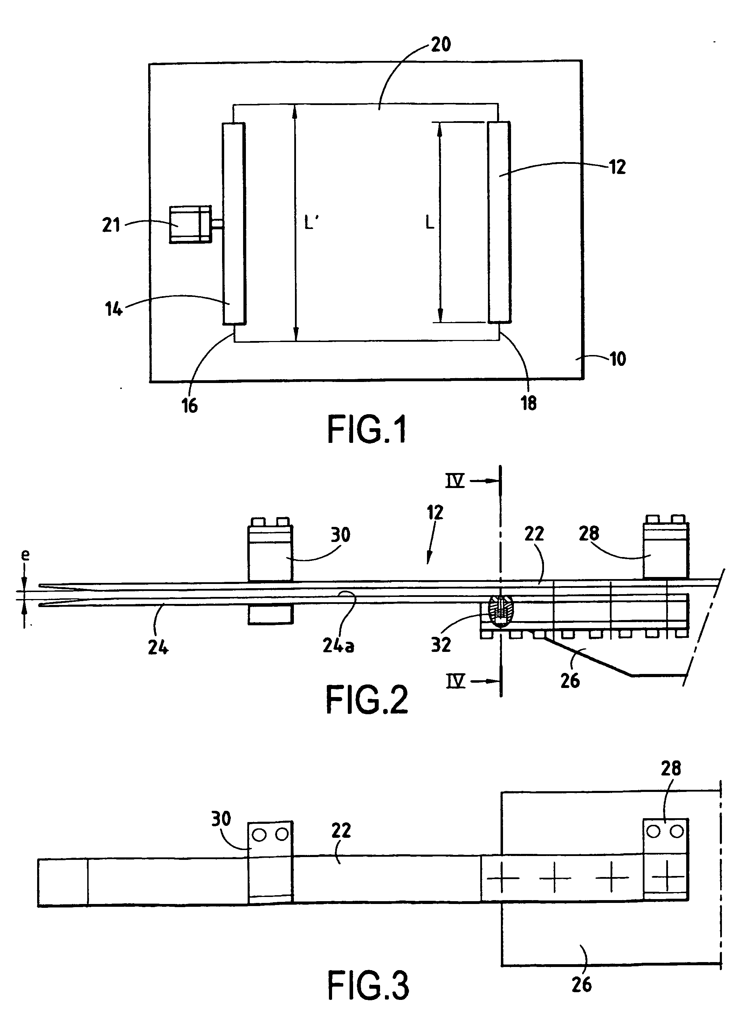

En se référant tout d'abord à la figure 1, on va décrire le principe du dispositif de maintien du panneau de circuit imprimé. Sur cette figure, on a représenté le bâti 10 du dispositif qui sera en fait le bâti de la machine sur laquelle le dispositif est monté.

Le dispositif de maintien comporte essentiellement deux moyens de saisie 12 et 14 que l'on appellera ultérieurement mâchoires de saisie. Ces mâchoires 12 et 14 permettent de saisir les deux bords parallèles 16 et 18 du panneau de circuit imprimé 20 dont on veut garantir la planéité. La mâchoire 12 par exemple est fixe par rapport au bâti et la mâchoire 14 peut être déplacée par exemple à l'aide d'un vérin 21.

On comprend qu'ainsi on peut exercer une tension sur le panneau 20, ce qui permet d'assurer le maintien de la planéité de celui-ci. Il faut bien sûr souligner que la longueur L de chaque mâchoire 12 ou 14 doit être sensiblement du même ordre que la longueur L' du plus grand panneau afin d'assurer la planéité sur toute la longueur de celui-ci.

En se référant aux figures 2 et 3, on va décrire le principe de réalisation de chacune des mâchoires de saisie d'un bord du panneau. On décrira par exemple la mâchoire 12. Celle-ci est constituée essentiellement par deux réglettes 22 et 24 qui sont disposées en regard l'une de l'autre et qui sont assujetties à rester parallèles l'une à l'autre. La réglette inférieure 24 est solidaire du bâti 10 par l'intermédiaire par exemple d'une plaque 26. La réglette supérieure 22 est mobile par rapport à la réglette 24 de telle manière que la réglette supérieure puisse occuper une position de repos dans laquelle écartement entre les deux réglettes e est supérieur à l'épaisseur maximale d'un panneau de circuit imprimé et de la flèche de celui-ci et une deuxième position de serrage dans laquelle les faces des réglettes 22 et 24 exercent une pression sur les deux faces du panneau de circuit imprimé 20. Par exemple, la réglette supérieure 22 est solidaire de deux ensembles de rapprochement 28 et 30 qui seront décrits plus en détails ultérieurement. Dans ce mode de réalisation, la saisie d'un bord du panneau est réalisée non seulement par la pression exercée par les réglettes 22 et 24 lorsqu'elles sont rapprochées mais également par des tiges telles que 32 qui sont montées mobiles réparties sur la longueur de la réglette 24 de telle manière qu'en position sortie, ces tiges 32 qui présentent une extrémité pointue fassent saillie hors de la face supérieure 24a de la réglette inférieure 24. On décrira ultérieurement plus en détails l'ensemble de déplacement 28 ou 30.

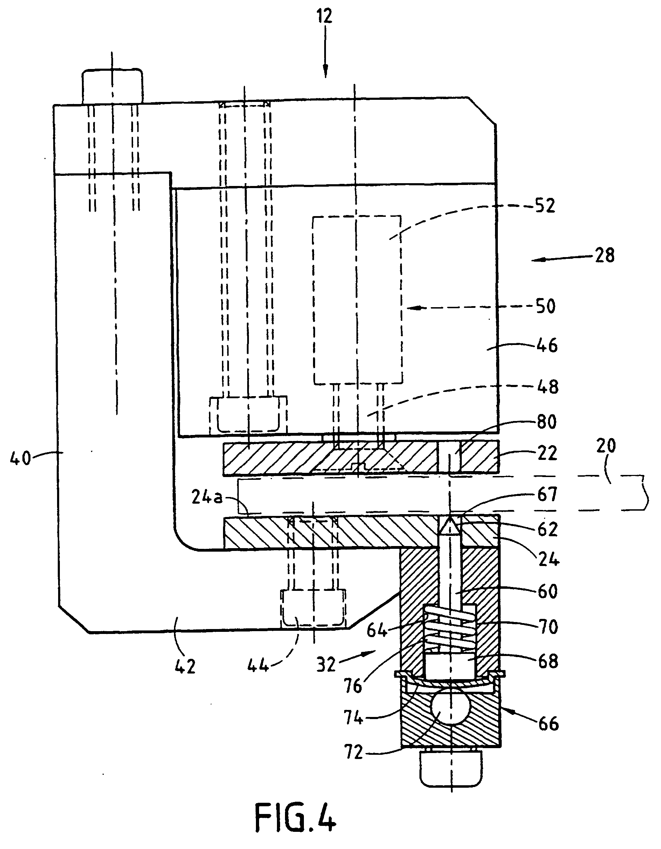

En se référant maintenant à la figure 4, on va décrire plus en détails un mode préféré de réalisation de l'ensemble de rapprochement 28. Cet ensemble comprend un support 40 comportant une partie inférieure 42 sur laquelle est fixée la réglette inférieure 24, par exemple, à l'aide de vis 44. Le support 40 comporte également une partie supérieure 46 sur laquelle est montée mobile la réglette supérieure 22. La réglette 22 est solidaire de la tige 48 d'un vérin 50 dont le corps 52 est solidaire de la pièce 46. La tige 48 assujettit la réglette 22 à rester parallèle à la réglette 24. On comprend qu'en commandant le vérin 50, on provoque le rapprochement de la réglette 22 et donc le pincement du bord du panneau de circuit imprimé 20. Dans certains cas, il peut être intéressant de donner aux réglettes 22 et 24 une largeur k suffisante pour que les deux réglettes, lorsqu'elles enserrent le bord du panneau, imposent une direction à celui-ci.

Sur la figure 4, on a également représenté une tige escamotable 32 à extrémité pointue qui sert également au maintien du bord du panneau de circuit imprimé.

La tige proprement dite 60 présentant une extrémité pointue 62 est montée coulissante dans un logement 64 ménagé dans un corps 66 solidaire de la face inférieure de la réglette inférieure 24. Les corps 66 sont répartis sur la longueur de la réglette 24. Le logement 64 est prolongé par un trou 67 ménagé dans la réglette 24 pour permettre à la pointe 62 de la tige de faire saillie fors de la face supérieure de la réglette 24. A son autre extrémité, la tige 60 comporte une tête d'actionnement 68 disposée dans une partie élargie 70 du logement 64. Le corps 66 définit également une chambre de commande 72 qui est fermée par une membrane déformable 74. En introduisant un fluide sous pression dans la chambre 72, on provoque le déplacement de la membrane 74 et donc celui de la tige 60 dont l'extrémité pointue fait saillie hors de la réglette 24. Un ressort de rappel 76 tend à ramener la tige 60 dans sa position rentrée. De préférence, la réglette supérieure 22 présente un léger évidement 80 en regard de la tige 60.

On comprend que dans ce mode de réalisation, la saisie du bord du panneau de circuit imprimé est obtenue par le pincement de ce bord entre les réglettes 22 et 24 et par la pénétration de la pointe de la tige 60 dans le bord de la face inférieure du panneau.

Sur le même ensemble de rapprochement, on peut prévoir plusieurs tiges 60 disposées parallèlement selon la direction de la réglette 24, ces tiges étant commandées par la même chambre 72.

Il va de soi qu'on ne sortirait pas de l'invention si l'élément de rapprochement comportait seulement une réglette et les tiges 60, le serrage étant obtenu par la coopération des tiges et de la surface de serrage. Dans ce cas, il serait préférable que les tiges 60 soient montées dans la partie supérieure 22 des moyens de saisie, la réglette inférieure 24 constituant alors en plus une surface d'appui pour le bord de la face inférieure du panneau.

On comprend que les réglettes 22 et 24 des machoires 12 et 14 constituent deux rainures parallèles de guidage des bords opposés du panneau de circuit imprimé. Pour amener le panneau en position de travail, il est donc nécessaire de prévoir un convoyeur qui permet de déplacer le panneau par rapport aux machoires 12 et 14 pour amener celui-ci dans la position voulue après que les extrémités des bords du panneau aient été engagées dans les rainures aux glissières.

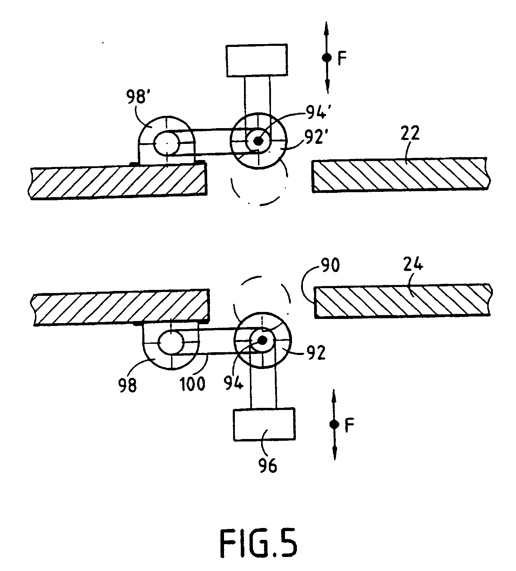

La figure 5 montre un mode de réalisation des machines de maintien qui permet de réaliser de plus le déplacement du panneau dans les rainures formées par les réglettes 22 et 24.

La réglette 24 comporte des trous régulièrement répartis sur sa longueur. En regard de chaque trou 90, est monté un galet 92 dont l'axe 94 est monté sur un support mobile en translation 96. Dans la position représentée sur la figure 5, les galets 92 sont en retrait par rapport à la face active de la réglette 24. En déplaçant le support selon la direction de la flèche F, on peut amener le galet dans une position active dans laquelle le galet 92 fait saillie dans la face active de la réglette 24. Chaque galet 92 est relié à un micromoteur 98 par l'intermédiaire d'un système de transmission 100. Chaque galet peut donc être entraîné en rotation autour de son axe 94.

La réglette 22 est également équipée de galets 92' à axes déplaçables 94' de telle manière que les galets 92' puissent occuper une position en retrait ou une position active dans laquelle ils font saillie dans la face de la réglette 22. Les galets 92' peuvent être montés fous sur leurs axes ou être entraînés en rotation par des micromoteurs 98'.

On comprend que lorsque les extrémités "d'attaque" des bords du panneau ont été engagées dans les rainures formées par les deux réglettes, celles-ci étant bien sûr en position écartée, on déplace les galets pour qu'ils fassent saillie dans la rainure et on commande leur rotation, ce qui produit l'avance du panneau.

Tout autre moyen que des galets permettant d'entraîner le panneau entre les deux réglettes peut être envisagé, par exemple : courroies...

Le dispositif de maintien selon l'invention peut avantageusement être utilisé dans une machine de poinçonnage de panneaux de circuits imprimés ou dans une machine d'exposition aux rayonnements pour réaliser des opérations d'impression à travers un ou plusieurs clichés sur un panneau de circuit imprimé.

## Revendications

1. Dispositif de maintien d'un panneau de circuit imprimé présentant deux bords sensiblement parallèles, **caractérisé en ce qu'**il comprend :
un bâti (10)
des premiers moyens (12) pour saisir un premier bord (16) dudit panneau (20), chaque moyen de saisie comportant une première pièce (22) formant une surface plane de serrage et une deuxième pièce (32) disposée en regard de la surface plane de serrage, ladite deuxième pièce comportant une pluralité de tiges montées coulissantes (32) selon une direction orthogonale à ladite surface de serrage et se terminant par une extrémité pointue, et des moyens pour déplacer lesdites tiges par rapport à ladite deuxième pièce pour rapprocher lesdites extrémités pointues de ladite surface de serrage plane,
des deuxièmes moyens (14) pour saisir le deuxième bord (18) dudit panneau ; et
des moyens (21) pour appliquer une force d'écartement entre les premiers et deuxièmes moyens de saisie, par quoi ledit panneau est maintenu plan.

2. Dispositif de maintien selon la revendication 1, **caractérisé en ce que** ladite deuxième pièce de chaque moyen de saisie comporte une surface additionnelle de serrage (24) disposée au regard de la surface de serrage et en ce chaque moyen de saisie comprend des moyens (28) pour déplacer relativement la surface de serrage par rapport à ladite surface additionnelle de serrage.

3. Dispositif selon l'une quelconque des revendications 1 et 2, **caractérisé en ce que** chaque tige comporte une deuxième extrémité opposée à ladite extrémité pointue et **en ce que** les moyens de déplacement desdites tiges comprennent une membrane déformable (74) disposée en regard des deuxièmes extrémités des tiges, une chambre étanche (72) fermée par ladite membrane et des moyens pour introduire dans ladite chambre un fluide sous pression par quoi la déformation de ladite membrane provoque le déplacement simultané desdites tiges.

4. Dispositif de maintien selon l'une quelconque des revendications 1 à 3, **caractérisé en ce que** les moyens d'écartement des deux moyens de saisie comprennent des moyens pour immobiliser le premier moyen de saisie par rapport au bâti et des moyens (21) pour exercer une traction sur les deuxièmes moyens de saisie par rapport audit bâti pour réaliser un écartement des deuxièmes moyens de saisie par rapport aux premiers moyens de saisie.

5. Dispositif de maintien selon la revendication 2, **caractérisé en ce que**, au repos, lesdites surfaces de serrage de chaque ensemble de saisie définissent entre elles une rainure apte à recevoir un bord du panneau de circuit imprimé.

6. Dispositif de maintien selon la revendication 5, **caractérisé en ce que** au moins une des pièces définissant une surface de serrage comporte des galets d'entraînement (92) du bord du panneau de circuit imprimé, des moyens pour déplacer (96) les axes desdits galets par rapport à ladite pièce entre une première position où lesdits galets font saillie hors de ladite surface de serrage et une deuxième position dans laquelle lesdits galets sont entièrement rentrés dans ladite pièce, et des moyens pour entraîner en rotation (98, 100) chaque galet autour de son axe (94), par quoi ledit panneau de circuit imprimé est entraîné en translation dans lesdites rainures par rapport audit dispositif de maintien.

7. Application du dispositif de maintien selon l'une quelconque des revendications 1 à 6 à la réalisation d'une machine de poinçonnage de panneaux de circuit imprimé.

8. Application du dispositif de maintien selon l'une quelconque des revendications 1 à 6 à la réalisation d'une machine d'exposition à la lumière de panneaux de circuit imprimé.

## Patentansprüche

1. Vorrichtung zum Halten einer zwei im Wesentlichen parallele Ränder aufweisenden Leiterplatte, **dadurch gekennzeichnet, dass** sie folgendes umfasst:
einen Rahmen (10),
erste Mittel (12) zum Ergreifen eines ersten Randes (16) der Platte (20), wobei jedes Greifmittel ein eine plane Klemmfläche bildendes erstes Teil (22) und ein gegenüber der planen Klemmfläche angeordnetes zweites Teil (32) aufweist, welches zweite Teil eine Mehrzahl von Stangen (32) aufweist, die in einer Richtung rechtwinkelig zur Klemmfläche gleitend gelagert sind und in einem spitz zulaufenden Ende enden, sowie Mittel zum Verschieben der Stangen in Bezug auf das zweite Teil zum Annähern der spitz zulaufenden Enden an die plane Klemmfläche,
zweite Mittel (14) zum Ergreifen des zweiten Randes (18) der Platte; und
Mittel (21) zum Anlegen einer Beabstandungskraft zwischen den ersten und den zweiten Greifmitteln, mit welcher die Platte eben gehalten wird.

2. Haltevorrichtung nach Anspruch 1, **dadurch gekennzeichnet, dass** das zweite Teil jedes Greifmittels eine gegenüber der Klemmfläche angeordnete zusätzliche Klemmfläche (24) aufweist und jedes Greifmittel Mittel (28) zum relativen Verschieben der Klemmfläche in Bezug auf die zusätzliche Klemmfläche aufweist.

3. Vorrichtung nach einem der Ansprüche 1 und 2, **dadurch gekennzeichnet, dass** jede Stange ein zweites, dem spitz zulaufenden Ende gegenüberliegendes Ende aufweist und die Mittel zum Verschieben der Stangen eine gegenüber den zweiten Enden der Stangen angeordnete verformbare Membran (74), eine durch die Membran geschlossene dichte Kammer (72) und Mittel zum Einbringen eines Druckfluids in die Kammer aufweisen, wodurch die Verformung der Membran die gleichzeitige Verschiebung der Stangen bewirkt.

4. Haltevorrichtung nach einem der Ansprüche 1 bis 3, **dadurch gekennzeichnet, dass** die Beabstandungsmittel der beiden Greifmittel Mittel zum Fixieren des ersten Greifmittels in Bezug auf den Rahmen und Mittel (21) zum Ausüben eines Zugs auf die zweiten Greifmittel in Bezug auf den Rahmen zum Herstellen eines Abstands der zweiten Greifmittel in Bezug auf die ersten Greifmittel aufweisen.

5. Haltevorrichtung nach Anspruch 2, **dadurch gekennzeichnet, dass** die Klemmflächen jeder Greifeinheit in der Ruheposition zwischen ihnen eine Rille zur Aufnahme eines Randes der Leiterplatte festlegen.

6. Haltevorrichtung nach Anspruch 5, **dadurch gekennzeichnet, dass** mindestens eines der eine Klemmfläche festlegenden Teile Rollen (92) zum Antreiben des Randes der Leiterplatte, Mittel (96) zum Verschieben der Achsen der Rollen in Bezug auf das Teil zwischen einer ersten Position, in der die Rollen von der Klemmfläche abstehen, und einer zweiten Position, in der die Rollen zur Gänze im Teil eingezogen sind, und Mittel (98, 100) zum drehenden Antreiben jeder Rolle um ihre eigene Achse (94) aufweist, wodurch die Leiterplatte in den Rillen in Bezug auf die Haltevorrichtung in Translationsbewegung versetzt wird.

7. Anwendung der Haltevorrichtung nach einem der Ansprüche 1 bis 6 bei der Realisierung einer Lochungsmaschine für Leiterplatten.

8. Anwendung der Haltevorrichtung nach einem der Ansprüche 1 bis 6 bei der Realisierung einer Belichtungsmaschine für Leiterplatten.

## Claims

1. A holding device for holding a printed circuit panel having two substantially parallel margins, the device being **characterised in that** it comprises:
- a frame (10);
- first grasping means (12) for grasping a first margin (16) of said panel (20), each grasping means having a first part (22) forming a plane clamping surface and a second part (32) disposed facing the plane clamping surface, said second part having a plurality of rods (32) mounted to slide in a direction orthogonal to said clamping surface and terminated in respective pointed ends, and means for displacing said rods relative to said second part to move said pointed ends towards said plane clamping surface;
- second grasping means (14) for grasping the second margin (18) of said panel; and
- means (21) for applying a separating force between the first and second grasping means, thereby keeping said panel plane.

2. A holding device according to claim 1, **characterised in that** said second part of each grasping means has an additional clamping surface (24) disposed facing said clamping surface, and **in that** each grasping means includes means (28) for moving said clamping surface relative to said additional clamping surface.

3. A device according to claim 1 or 2, **characterised in that** each rod has a second end opposite said first end, and **in that** the means for displacing said rods comprise a deformable membrane (74) disposed in register with the second ends of the rods, a leakproof chamber (72) closed by said membrane, and means for admitting into said chamber a fluid under pressure so that deformation of said membrane causes said rods to move simultaneously.

4. A holding device according to any one of claims 1 to 3, **characterised in that** the means for separating the two grasping means comprise means for preventing the first grasping means from moving relative to the frame, and means (21) for exerting traction on the second grasping means relative to said frame so as to cause the second grasping means to become separated relative to the first grasping means.

5. A holding device according to claim 2, **characterised in that**, at rest, said clamping surfaces of each grasping assembly define between them a slot suitable for receiving a margin of a printed circuit panel.

6. A holding device according to claim 5, **characterised in that** at least one of the parts defining a clamping surface has drive wheels (92) for driving the margin of a printed circuit panel, means (96) for moving the axes of said wheels relative to said part between a first position in which said wheels project from said clamping surface and a second position in which said wheels are fully retracted into said part, and means (98, 100) for driving each wheel in rotation about its axis (94), whereby said printed circuit panel is driven in translation along said slots relative to said holding device.

7. The use of the holding device according to any one of claims 1 to 6, in making a machine for punching printed circuit panels.

8. The use of the holding device according to any one of claims 1 to 6, in making a machine for exposing a printed circuit panel to light.
